# EUROPEAN PATENT APPLICATION

(11) **EP 4 306 498 A1**
(43) Date of publication of application: **17.01.2024**
(21) Application number: 23184531.4
(22) Date of filing: 10.07.2023
(51) Int. Cl.: C04B 35/628, C04B 35/80, C23C 16/30

(54) **HIGH ENTROPY CERAMIC FOR PROTECTION OR MULTI-LAYER IFC**

(30) Priority: 15.07.2022 US 202217866016
(71) Applicant: RTX Corporation, Farmington, CT 06032 (US)
(72) Inventor: PETROSKI, Kenneth, East Hartford, 06118 (US); COLBY, Mary, East Hartford, 06118 (US); LAZUR, Andrew Joseph, East Hartford, 06118 (US)
(74) Representative: Dehns

(57) **Abstract**

A ceramic matrix composite includes a fiber (12), a first interface coating layer (18) disposed adjacent to an outer surface of the fiber (12), and a first protective layer (22) disposed outward of the first interface coating layer (18) and the fiber (12). The first protective layer (22) comprises a high entropy ceramic. A method of protecting a fiber (12) of a ceramic matrix composite includes depositing, by chemical vapor deposition or chemical vapor infiltration, a first interface coating layer (18) on the fiber (12); and depositing, by chemical vapor deposition or chemical vapor infiltration, a first protective layer (22) outward of the first interface coating layer (18). The first protective layer (22) comprises a high entropy ceramic.

## Description

### BACKGROUND

The present invention relates generally to ceramic matrix composites and more particularly to the formation of fiber protective layers.

Fiber-reinforced ceramic matrix composites (CMCs) have been developed for the manufacture of components that are exposed to high temperatures, corrosive environments, and mechanical stress. CMCs are of particular interest in the aerospace industry and their use has been widely adopted for high temperature aircraft applications. While CMCs can provide superior properties, they are susceptible to degradation. Over time, ceramic materials can form microcracks that expose the ceramic material to oxygen or other corrosive elements. To limit damage to fibers or through thickness cracks, fibers can be coated with one or more rigidized interfacial coating (IFC) layers, which can arrest and deflect cracks. While providing some protection, current interfacial coatings do not have adequate oxidation resistance or stability at elevated temperatures and are susceptible to degradation over time. Protective barrier layers such as silicon carbide, silicon nitride, and boron carbide used to provide a diffusion barrier to protect IFC layers and fibers are also susceptible to degradation. For example, the passivation oxide layer formed by SiC/SiO₂ is vulnerable to moisture attack at high temperatures, forming Si(OH)₄ and degrading the CMC.

New protective materials and coating schemes with greater oxidation resistance and stability at high temperatures and in corrosive environments are desirable to enhance survivability of the CMC components during operation.

### SUMMARY

In one aspect, a ceramic matrix composite includes a fiber, a first interface coating layer disposed adjacent to an outer surface of the fiber, and a first protective layer disposed outward of the first interface coating layer and the fiber. The first protective layer comprises a high entropy ceramic.

In another aspect, a method of protecting a fiber of a ceramic matrix composite includes depositing, by chemical vapor deposition or chemical vapor infiltration, a first interface coating layer on the fiber; and depositing, by chemical vapor deposition or chemical vapor infiltration, a first protective layer outward of the first interface coating layer. The first protective layer comprises a high entropy ceramic.

Features of embodiments are set forth in the dependent claims.

The present summary is provided only by way of example, and not limitation. Other aspects of the present disclosure will be appreciated in view of the entirety of the present disclosure, including the entire text, claims and accompanying figures.

### BRIEF DESCRIPTION OF THE DRAWINGS

FIG. 1 is a cross-sectional view of a multi-layer fiber coating system for a CMC component.
FIG. 2 is a simplified cross-sectional view of another multi-layer fiber coating system for a CMC component.
FIG. 3 is a simplified cross-sectional view of yet another multi-layer fiber coating system for a CMC component.
FIG. 4 is a flow chart illustrating select steps of a method for forming a CMC component having a fiber coating system, such as the multi-layer fiber coating system of FIG. 1, including multiple high entropy ceramic protective layers.

While the above-identified figures set forth embodiments of the present invention, other embodiments are also contemplated, as noted in the discussion. In all cases, this disclosure presents the invention by way of representation and not limitation. It should be understood that numerous other modifications and embodiments can be devised by those skilled in the art, which fall within the scope and spirit of the principles of the invention. The figures may not be drawn to scale, and applications and embodiments of the present invention may include features, steps and/or components not specifically shown in the drawings.

### DETAILED DESCRIPTION

The present disclosure is directed to a multilayer protective structure for a CMC component. More specifically, this disclosure presents a protective layer formed of a high entropy carbide, boride, nitride, or carbonitride (referred to hereinafter as a high entropy ceramic) that can be deposited over a rigidized interface coating (IFC) layer to slow the diffusion of oxygen and other chemicals, which could degrade the IFC layer during processing and operation of ceramic matrix composite (CMC) components. High entropy ceramics have lower oxygen diffusivity as compared to binary barrier layer materials, such as silicon carbide, silicon nitride, and boron carbide. In addition to providing improved oxidation resistance, high entropy ceramics can provide additional mechanical property advantages, such as increased hardness and strength, and high temperature stability. The disclosed protective layer can be applied to protect one or more IFC layers. The protective layer is designed to slow the diffusion of oxygen and other chemicals that could cause degradation through the composite and is intended to prevent oxygen from reaching the IFC layer. When applied as thin films to fibers of a CMC, the protective layer can provide sufficient CMC protection while minimizing a contribution to the overall weight of the CMC component. Some elements of high entropy ceramics are heavy and have the potential for substantially increasing the weight of CMCs; however, this impact can be significantly reduced when the high entropy ceramic is applied as a thin film coating (e.g., 1-100 or 1-50 nanometers in thickness).

As used herein, the term "high entropy ceramic" refers to an entropy-stabilized single phase carbide, boride, nitride, or carbonitride that contains at least four different metal or metalloid cations, each providing significant (not necessarily equiatomic) contribution to the material, in a cationic matrix. The various sizes and electronegativities of the cations in the cationic matrix serve to slow the migration of oxygen and other chemicals through the high entropy phase. Silicon and refractory metal cations, including titanium, chromium, zirconium, hafnium, vanadium, niobium, tantalum, molybdenum, and tungsten can be suitable candidates for the disclosed high entropy ceramic protective layers to provide high strength and stability in ultra-high temperature operating conditions.

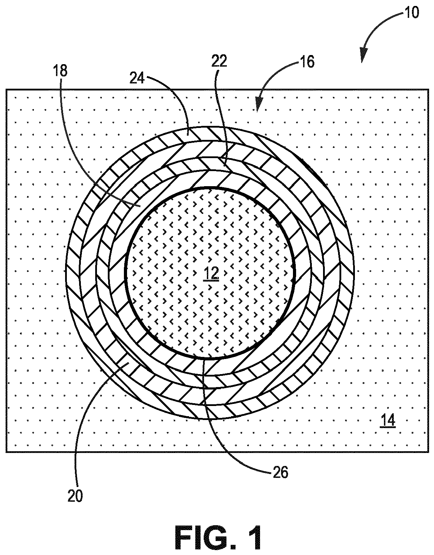

FIG. 1 is a cross-sectional view of a fiber coating system for a CMC component. FIG. 1 shows an enlarged view of a portion of CMC component 10 including fiber 12 disposed in matrix 14. Fiber 10 includes fiber coating system 16, having IFC layers 18 and 20, protective layers 22 and 24, and optional carbon layer 26. CMC component 10 can be, for example, a component suitable for use in a gas turbine engine and, particularly, a component suitable for use in high temperature and/or corrosive environments (e.g., turbine blades, vanes, seals, and platforms, and combustor panels). Although FIG. 1 depicts a single fiber and fiber coating system, it will be understood that the CMC component would include a plurality of fibers having the disclosed fiber coating system.

Fiber coating system 16 can include multiple IFC layers and multiple protective layers arranged in alternating fashion. As illustrated in FIG. 1, fiber coating system 16 includes two IFC layers 18, 20 and two protective layers 22, 24 arranged in an alternating fashion, however, will be understood by one of ordinary skill in the art that any number of IFC layers and protective layers can be provided and the number of IFC layers and protective layers is not limited to the number shown. While multiple IFC and protective layers can provide multiple layers of protection in the event failure occurs in one or more outer layers, in some embodiments, the fiber coating system can include a single IFC layer and a single protective layer. In addition to the IFC layers 18, 20 and protective layers 22, 24, one or more intervening layers of differing chemical composition can be provided to enhance bonding and/or material properties of the CMC without departing from the present disclosure.

Fibers 12 can be generally cylindrical formed into bundled silicon fiber tows and arranged in woven, braided, or non-woven unidirectional or multidirectional architectures. Other fiber materials known in the art for use in various environmental conditions and operating temperatures are contemplated. Fibers 12 can typically make up approximately 20 to 50 percent by volume of the CMC and preferably, can make up 30 to 40 percent by volume of the CMC. In some embodiments, fiber coating system 16 can be applied to encapsulate individual fibers 12. In other embodiments, fiber coating system 16 can be alternatively or additionally applied to cover or encapsulate fiber tows.

IFC layer 18 can be deposited on fiber 12 and can generally conform to outer surface of fiber 12 or coat fiber 12. IFC layer 18 can be deposited directly on fiber 12 or can be deposited on an intervening layer. For example, in some embodiments, optional carbon layer 26 can be deposited on fiber 12 prior to deposition of IFC layer 18. Carbon layer 26 can be deposited by any suitable means including, for example, chemical vapor deposition (CVD) or chemical vapor infiltration (CVI). In some embodiments, carbon layer 26 can be formed as a residual component of thermal processing of the silicon carbide fiber preform, for example, when a binding agent is burned off. Epitaxial growth on carbon layer 26 can improve bonding of IFC layer 18. IFC layer 18 can be deposited by any suitable means, including CVD/CVI. In some embodiments, IFC layer 18 can be deposited on individual fibers 12 or fiber tows prior to fiber layup or can be deposited on fibers 12 or fiber tows in a fiber preform of CMC component 10 or woven or braided fiber sheet. IFC layer 18 can be a de-bonding layer formed from boron nitride, silicon-doped boron nitride, a combination boron nitride and silicon-doped boron nitride, or other suitable materials known in the art. In some embodiments, IFC layer 18 formed of boron nitride can be deposited to include an anisotropic region characterized by a more crystalline three-dimensional structure of hexagonal boron nitride (h-BN), which can provide improved oxidation resistance and/or toughness. Silicon-doped boron nitride can also improve oxidation resistance over conventional boron nitride coatings. IFC layer 18 can have a thickness of 50 to 100 microns.

Protective layer 22 can be deposited on IFC layer 18 by CVD/CVI. Protective layer 22 can be deposited on individual fibers 12 prior to fiber layup or can be deposited on fibers 12 in a fiber preform or woven or braided fiber sheet. Protective layer 22 can fully coat IFC layer 18. Protective layer 22 is a high entropy ceramic, including refractory metal cations suitable for high temperature operational conditions. In some embodiments, protective layer 22 can be formed of high entropy carbides which can include, for example, MoNbTaVWCs, HfNbTaTiZrC₅, and HfNbTaTiVCs. In some embodiments, protective layer 22 can be formed of high entropy nitrides and carbonitrides which can include, for example, (HfNbTaTiZr)N and (HfNbTaTiZr)CN. In some embodiments, protective layer 22 can be formed of high entropy borides which can include, for example, (Hf_{0.2}Zr_{0.2}Ta_{0.2}Nb_{0.2}Ti_{0.2})B₂, (Hf_{0.2}Zr_{0.2}Ta_{0.2}Mo_{0.2}Ti_{0.2})B₂, (Hf_{0.2}Zr_{0.2}Mo_{0.2}Nb_{0.2}Ti_{0.2})B₂, (Hf_{0.2}Mo_{0.2}Ta_{0.2}Nb_{0.2}Ti_{0.2})B₂, (Mo_{0.2}Zr_{0.2}Ta_{0.2}Nb_{0.2}Ti_{0.2})B₂, and (Hf_{0.2}Zr_{0.2}Ta_{0.2}Cr_{0.2}Ti_{0.2})B₂. Protective layer 24 can have a thickness of approximately 1-100 nanometers or 1-50 nanometers.

Carbides can provide the highest temperature capability of the disclosed protective layers 22, however, multiple considerations can be made in material selection. While it may be desirable to select a particular cationic system (e.g., Hf, Zr, Ta, Cr, Nb) to contribute a mixture of desirable properties (e.g., oxidation resistance from chromium, high temperature capability from hafnium, etc.) such cationic system will not necessarily form a single entropy-stabilized phase. Use of a different anionic matrix (i.e., boride or nitride in place of carbide) for a desired cationic system may improve the opportunity to form a single phase entropy-stabilized system. Ease of chemical synthesis, material costs, and material weight are additional factors that can be considered in material selection.

IFC layer 20 can be deposited on protective layer 22 via CVD/CVI. IFC layer 20 can be formed of the same material as IFC layer 18 or can comprise a different material known in the art. IFC layer 20 can be deposited on individual fibers 12 prior to fiber layup or can be deposited on fibers 12 in a fiber preform or woven or braided fiber sheet. IFC layer 20 can fully coat protective layer 22. IFC layer 20 can have a thickness substantially the same as the thickness of IFC layer 18. For example, IFC layer 20 can have a thickness in the range of 1-100 microns. In other embodiments, IFC layer 20 can have a thickness that is greater than or less than the thickness of IFC layer 18. The thicknesses of IFC layers 18 and 20 can be balanced to provide load transfer and ductility while not impacting an overall stiffness of the fiber preform. The thicknesses of each layer can impart a residual stress on the previously deposited layer, and therefore, can be minimized to a thickness necessary to provide adequate protection of fibers 12.

Protective layer 24 can be deposited on IFC layer 20 by CVD/CVI. Protective layer 24 can be deposited on individual fibers 12 prior to fiber layup or can be deposited on fibers 12 in a fiber preform or woven or braided fiber sheet. Protective layer 24 can fully coat IFC layer 20. Protective layer 24 is a high entropy ceramic, including refractory metal cations suitable for high temperature operational conditions. Protective layer 24 can be formed of the same material as protective layer 22 or can be formed of a different material. Incorporation of protective layers 22, 24 formed of different materials may provide the ability to tailor thermal expansion between layers of the CMC to minimize internal stresses. Protective layer 24 can have a thickness of approximately 1-100 nanometers or 1-50 nanometers.

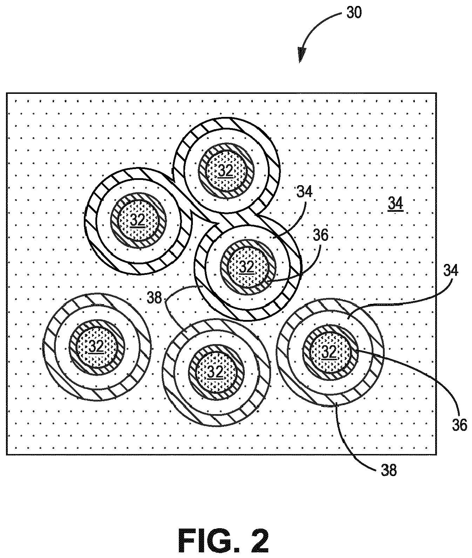

In some embodiments, a high entropy ceramic can be provided in the matrix of the CMC in addition to or in place of protective layers 22 and 24 in fiber coating system 16. For example, a high entropy ceramic can be deposited via CVI in the matrix surrounding fibers 12 during a CMC densification process as illustrated in FIG. 2. FIG. 2 shows a simplified enlarged view of a portion of CMC component 30 including fibers 32 disposed in matrix 34. Fibers 32 include a multi-layer fiber coating system including IFC layer 36 and protective layer 38 with matrix 34 disposed therebetween. Fibers 32, matrix 34, IFC layer 36, and protective layer 38 can be substantially the same as fiber 12, matrix 14, IFC layers 18, 20, and protective layers 22, 24 disclosed with respect to FIG. 1. Each fiber 32 can be coated with IFC layer 36, matrix 34, and protective layer 38. Protective layer 38 can fully surround or envelop each fiber 32. A thickness of matrix 34 disposed between IFC layer 36 and protective layer 38 can vary depending on a distance between adjacent fibers 32. For example, densification with matrix 34 can be limited to promote deposition of protective layer 38 around each fiber 32. As previously described, fibers 32 can include single fibers or fiber bundles. As illustrated, matrix 34 between IFC layer 36 and protective layer 38 is the same material as matrix 34 surrounding protective layer 38. In other embodiments, the innermost matrix layer can be formed of a different material than the outermost matrix layer.

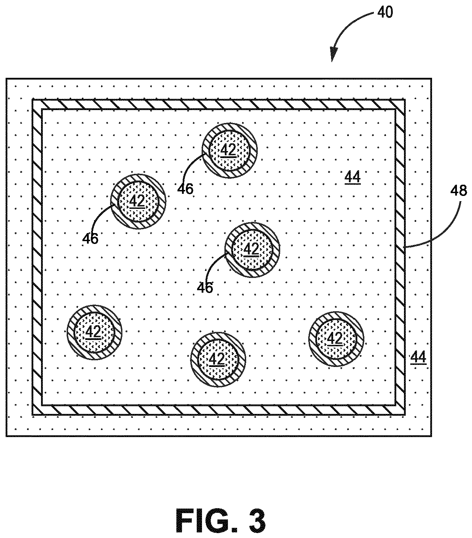

FIG. 3 is a simplified cross-sectional view of yet another fiber coating system for a CMC component. FIG. 3 shows an enlarged view of a portion of CMC component 40, including fibers 42, matrix 44, IFC layer 46, and protective layer 48. Fibers 42 can be individually coated with IFC layer 46 and disposed in matrix 44. Protective layer 48 can be disposed around a group of fibers 42. Fibers 42, matrix 44, IFC layer 46, and protective layer 48 can be substantially the same as fiber 12, matrix 14, IFC layers 18, 20, and protective layers 22, 24 disclosed with respect to FIG. 1. As previously described, fibers 42 can include single fibers or fiber bundles. As illustrated, matrix 44 between fibers 42 and protective layer 48 is the same material as matrix 44 surrounding protective layer 48. In other embodiments, the innermost matrix layer can be formed of a different material than the outermost matrix layer.

The multi-layer coating fiber coating systems illustrated in FIGS. 2 and 3 can optionally include a carbon layer as described with respect to FIG. 1. Furthermore, additional IFC layers separated by matrix material (e.g., silicon carbide) can be included. As illustrated, matrix 34 in FIG. 2 and matrix 44 in FIG. 3 is the same material in both arrangements.

In some embodiments, a high entropy ceramic layer can be provided in discrete regions of the CMC component, e.g., regions more susceptible degradation during operation. The high entropy ceramic can be provided as one or more thin layers in the matrix to minimize an increase in component weight caused by incorporation of heavier elements of the high entropy ceramic.

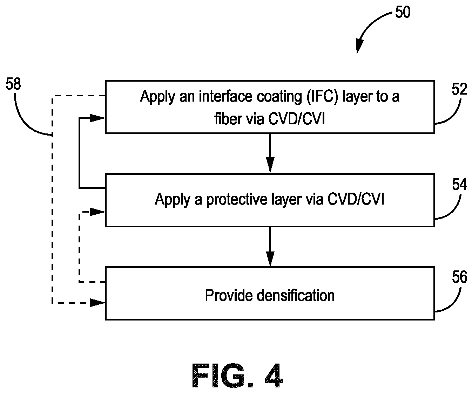

FIG. 4 is a flow chart illustrating select steps of method 50 for forming a CMC component having a fiber coating system, such as fiber coating system 16 of FIG. 1, including a high entropy ceramic protective layer. Method 50 may include additional steps (not shown) without departing from the present disclosure.

At step 52, an IFC layer is applied to a fiber via CVD/CVI. The IFC layer can be deposited on a plurality of fibers to coat an outer surface of the fibers. The IFC layer can be deposited on individual fibers prior to fiber layup or can be deposited on fibers in a fiber preform or woven or braided fiber sheet placed in a CVD/CVI reaction chamber as known in the art. The IFC layer can be a de-bonding layer formed from boron nitride, silicon-doped boron nitride, a combination of boron nitride and silicon-doped boron nitride, or other suitable materials known in the art and as described with respect to FIG. 1 using known CVD/CVI methods. The IFC layer can have a thickness generally ranging from 1-100 microns. The thickness of the IFC layer can be varied depending on the chemical composition of the IFC layer, number of IFC layers present in the coating system, and the presence of other protective layers.

In some embodiments, a carbon layer can be deposited on fibers or can be formed on fibers through thermal decomposition prior to deposition of the IFC layer, as described with respect to FIG. 1. Epitaxial growth on the carbon layer may improve bonding of the IFC layer and provide additional protection of the fiber.

At step 54, a protective layer can be deposited on or outward the IFC layer by CVD/CVI. The protective layer can fully coat the IFC layer to protect the IFC layer and underlying fiber. The protective layer is a high entropy ceramic, including refractory metal cations suitable for high temperature operational conditions. As described with respect to FIG. 1, the protective layer can be a high entropy carbide, boride, nitride, or carbonitride. Examples of high entropy carbides include MoNbTaVWCs, HfNbTaTiZrC₅, and HfNbTaTiVCs. Examples of high entropy nitrides and carbonitrides include (HfNbTaTiZr)N and (HfNbTaTiZr)CN. Examples of high entropy borides include (Hf_{0.2}Zr_{0.2}Ta_{0.2}Nb_{0.2}Ti_{0.2})B₂, (Hf_{0.2}Zr_{0.2}Ta_{0.2}Mo_{0.2}Ti_{0.2})B₂, (Hf_{0.2}Zr_{0.2}Mo_{0.2}Nb_{0.2}Ti_{0.2})B₂, (Hf_{0.2}Mo_{0.2}Ta_{0.2}Nb_{0.2}Ti_{0.2})B₂, (Mo_{0.2}Zr_{0.2}Ta_{0.2}Nb_{0.2}Ti_{0.2})B₂, and (Hf_{0.2}Zr_{0.2}Ta_{0.2}Cr_{0.2}Ti_{0.2})B₂.

The protective layer can be deposited by simultaneously flowing gases including precursors of at least four carbides, borides, nitrides, or carbonitrides, including at least one, or at least two, or at least three, or at least four different refractory carbides, borides, nitrides, or carbonitrides (referred to herein as "refractory materials"), to form the cationic system, and a precursor gas to form the anionic matrix into a reaction chamber containing the fiber. For example, the protective layer can be deposited by simultaneously flowing a first gas comprising precursors of a first refractory material, a second gas comprising precursors of a second refractory material, a third gas comprising precursors of a third refractory material, and a fourth gas comprising precursors of a fourth refractory material. The precursor gases mix to produce a high entropy ceramic characterized as a single phase solid solution of cations of the at least four refractory materials in an anionic matrix. For example, precursors of a first refractory material may be CH₄ and TaCl₅, which react to form TaC. Precursor gas for the anionic matrix can include, for example, CH₄ for carbon, NH₃ for nitrogen, or BCl₃ for boron. Hydrogen or nitrogen may also be introduced into the reaction chamber to facilitation the reaction and control deposition, as necessary.

As opposed to mixtures of refractory materials characterized by a principal refractory material with minor additions of other refractory materials, each refractory material of the high entropy ceramic provides a significant contribution to the material composition. In some systems, the high entropy ceramic can have an equiatomic composition of at least four cations (e.g., four refractory materials). In other systems, the high entropy ceramic can have a non-equiatomic composition of at least four cations (e.g., refractory materials) with each refractory material making up at least 5-35 atomic percent of the cations of the material composition. The material composition can be controlled by controlling the flow rate and/or concentration of the precursor gases. The precursor gases can be delivered to the reaction chamber to provide the refractory materials in an atomic ratio determined necessary to form the high entropy ceramic. The flow of the precursor gases can be additionally modulated to account for variations in kinetics of the formation of different refractory materials.

The selection of the at least four materials forming the cationic system, including the one or more refractory materials can be made based on the desired material properties of the resultant protective layer (e.g., melting temperature, toughness, oxygen resistance, etc.), material weight, material cost, and contribution to entropy stabilization.

Materials forming the cationic system, including refractory materials can be provided to the reaction chamber as metal halides, including but not limited to fluorides, bromides, and chlorides. Precursors easier to volatilize through vaporization/sublimation can be preferred for ease of processing. Deposition can be performed at a temperature that can range, for example, from approximately 800 °C to 2000 °C, and pressure ranging between 1 and 50 Torr (0.13 and 6.67 kPa). Carrier gases can include, for example, hydrogen, nitrogen, and argon.

In some embodiments, steps 52 and 54 can be repeated to provide one or more additional IFC and protective layers. For example, the CVD/CVI process can alternate between steps 52 and 54 to form a multi-layered coating system with alternating IFC and protective layers with a protective layer coating an outermost IFC layer. A single IFC layer and protective layer may provide sufficient oxidation resistance and protection of the fiber in some embodiments. In other embodiments, one or more additional IFC layers and protective layers may be provided to further limit degradation should an outermost protective layer be compromised.

In some embodiments, fibers having the disclosed coating system can be arranged, for example, as fabric plies, braids, tapes, in a layered stacking arrangement or can be three-dimensionally woven to form a fiber preform of a component. In other embodiments, fibers having a portion of the disclosed coating system-for example, a single IFC layer-can be arranged to form a fiber preform or fiber sheet and further layers of the disclosed coating system, including one or more protective layers and, optionally, one or more additional IFC layers, can be applied to the fibers of the preform or fiber sheet via CVD/CVI. In some embodiments, all layers of the disclosed coating system can be applied to fibers arranged in a fiber preform via CVI.

At step 56, a preform of the CMC component incorporating the fibers coated according to steps 52 and 54 can be densified with a ceramic matrix. Densification can be achieved using CVI, polymer infiltration and pyrolysis, slurry infiltration, melt infiltration, and combinations thereof as known in the art. Densification can be carried out until the resulting CMC has reached the desired residual porosity.

In some embodiments, step 54 can be provided following a partial densification step 58 (shown in phantom) to introduce the high entropy ceramic into the matrix or to encapsulate fiber tows. In such embodiments, the high entropy ceramic may not directly contact the IFC layer but be disposed outward of the IFC layer in the matrix to protect the IFC layer from degradation. Densification step 56 is stopped to perform the additional step 54. Depending on the progress of densification of step 56, the additional high entropy ceramic layer can encapsulate fiber tows or can form discontinuous layers in the matrix.

Various optional post-processing steps (not shown) can be performed, such as the application of one or more protective coatings (e.g., environmental and/or thermal barrier coatings). A bond coat can also be applied to facilitate bonding between the CMC and a protective coating. Other protective coatings, especially those suitable for use in a gas turbine engine environment, are contemplated.

The disclosed fiber coating system incorporating a high entropy ceramic deposited over an IFC layer can slow the diffusion of oxygen and other chemicals, which could degrade the IFC layer during processing and operation of ceramic matrix composite (CMC) components. In addition to providing improved oxidation resistance over current binary material protective layers, high entropy ceramics can provide additional mechanical property advantages, such as increased hardness and strength, and high temperature stability. A CMC component formed with the disclosed fiber coating system can be particularly suited for high temperature and corrosive environments.

### Discussion of Possible Embodiments

The following are non-exclusive descriptions of possible embodiments of the present invention.

A ceramic matrix composite includes a fiber, a first interface coating layer disposed adjacent to an outer surface of the fiber, and a first protective layer disposed outward of the first interface coating layer and the fiber. The first protective layer comprises a high entropy ceramic.

The ceramic matrix composite of the preceding paragraph can optionally include, additionally and/or alternatively, any one or more of the following features, configurations and/or additional components:
The ceramic matrix composite of the preceding paragraph can further include a second interface coating layer disposed on the first protective layer and a second protective layer disposed on the second interface coating layer. The second protective layer comprises a high entropy ceramic. The first protective layer is disposed on the first interface coating layer.

The ceramic matrix composite of any of the preceding paragraphs can further include a plurality of fibers with each fiber coated with first and second interface coating layers and first and second protective layers.

The ceramic matrix composite of any of the preceding paragraphs, wherein the high entropy ceramic comprises at least one of a high entropy carbide, a high entropy nitride, a high entropy carbonitride, and a high entropy boride.

The ceramic matrix composite of any of the preceding paragraphs, wherein the high entropy ceramic comprises at least four cations including a refractory metal cation selected from group consisting of titanium, chromium, zirconium, hafnium, vanadium, niobium, tantalum, molybdenum, and tungsten.

The ceramic matrix composite of any of the preceding paragraphs, wherein the at least four cations includes a refractory metalloid cation.

The ceramic matrix composite of any of the preceding paragraphs, wherein the at least four cations includes silicon.

The ceramic matrix composite of any of the preceding paragraphs, wherein each of the four cations makes up at least 5 atomic percent of the cations in the high entropy ceramic.

The ceramic matrix composite of any of the preceding paragraphs, wherein the first protective layer has a thickness ranging from 1 to 100 nanometers.

The ceramic matrix composite of any of the preceding paragraphs, wherein the interface coating is boron nitride, or silicon-doped boron nitride, or a combination thereof.

The ceramic matrix composite of any of the preceding paragraphs, wherein the fiber further comprises a carbon layer disposed between the first interface coating layer and the outer surface of the fiber.

A method of protecting a fiber of a ceramic matrix composite includes depositing, by chemical vapor deposition or chemical vapor infiltration, a first interface coating layer on the fiber; and depositing, by chemical vapor deposition or chemical vapor infiltration, a first protective layer outward of the first interface coating layer. The first protective layer comprises a high entropy ceramic.

The method of the preceding paragraph can optionally include, additionally and/or alternatively, any one or more of the following features, configurations, additional components, and/or steps:
The method of the preceding paragraph can further include depositing, by chemical vapor deposition or chemical vapor infiltration, a second interface coating layer on the first protective layer; and depositing, by chemical vapor deposition or chemical vapor infiltration, a second protective layer on the second interface coating layer. The second protective layer comprises a high entropy ceramic. The first protective layer is deposited on the first interface coating layer.

The method of any of the preceding paragraphs, wherein the high entropy ceramic comprises at least one of a high entropy carbide, a high entropy nitride, a high entropy carbonitride, and a high entropy boride.

The method of any of the preceding paragraphs, wherein the high entropy ceramic comprises at least four cations, the at least four cations including a refractory metal cation selected from group consisting of titanium, chromium, zirconium, hafnium, vanadium, niobium, tantalum, molybdenum, and tungsten.

The method of any of the preceding paragraphs, wherein the at least four cations includes a refractory metalloid cation.

The method of any of the preceding paragraphs, wherein the at least four cations includes silicon.

The method of any of the preceding paragraphs, wherein depositing the first protective layer comprises simultaneously flowing, into a reaction chamber containing the fiber, a first gas comprising precursors of a first refractory material, a second gas comprising precursors of a second refractory material, a third gas comprising precursors of a third refractory material, and a fourth gas comprising precursors of a fourth refractory material, The first, second, third, and fourth refractory materials are different.

The method of any of the preceding paragraphs, wherein flowing the first, second, third, and fourth gases comprises modulating a gas flow rate of each of the first, second, third, and fourth gases to account for variations in kinetics between the first, second, third, and fourth gases and to produce a high entropy ceramic.

The method of any of the preceding paragraphs, wherein each refractory material makes up at least 5 atomic percent of the cations of the high entropy ceramic.

The method of any of the preceding paragraphs, wherein the first, second, third, and fourth refractory materials comprise at least one of a refractory carbide, a refractory nitride, a refractory carbonitride, and a refractory boride.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A ceramic matrix composite comprising:
a fiber (12; 32; 42);
a first interface coating layer (18; 36; 46) disposed adjacent to an outer surface of the fiber (12; 32; 42); and
a first protective layer (22; 38; 48) disposed outward of the first interface coating layer (18; 36; 46) and the fiber (12; 32; 42), wherein the first protective layer (22; 38; 48) comprises a high entropy ceramic.

2. The ceramic matrix composite of claim 1, and further comprising:
a second interface coating layer (20) disposed on the first protective layer (18); and
a second protective layer (24) disposed on the second interface coating layer (20),
wherein the second protective layer (24) comprises a high entropy ceramic,
wherein the first protective layer (22) is disposed on the first interface coating layer (18).

3. The ceramic matrix composite of claim 2, and further comprising a plurality of fibers (12), each fiber (12) coated with first and second interface coating layers (18; 20) and first and second protective layers (22; 24).

4. The ceramic matrix composite of any preceding claim, wherein the first protective layer (22; 38; 48) has a thickness ranging from 1 to 100 nanometers.

5. The ceramic matrix composite of any preceding claim, wherein the fiber (12) further comprises a carbon layer (26) disposed between the first interface coating layer (18) and the outer surface of the fiber (12).

6. The ceramic matrix composite of any preceding claim, wherein a matrix material (34; 44) is disposed between the first interface coating layer (36; 46) and the first protective layer (38; 48).

7. A method of protecting a fiber (12; 32; 42) of a ceramic matrix composite, the method comprising:
depositing, by chemical vapor deposition or chemical vapor infiltration, a first interface coating layer (18; 36; 46) on the fiber (12; 32; 42);
depositing, by chemical vapor deposition or chemical vapor infiltration, a first protective layer (22; 38; 48) outward of the first interface coating layer (18; 36; 46), wherein the first protective layer (22; 38; 48) comprises a high entropy ceramic.

8. The method of claim 7, and further comprising:
depositing, by chemical vapor deposition or chemical vapor infiltration, a second interface coating layer (20) on the first protective layer (18); and
depositing, by chemical vapor deposition or chemical vapor infiltration, a second protective layer (24) on the second interface coating layer (20),
wherein the second protective layer (24) comprises a high entropy ceramic,
wherein the first protective layer (22) is deposited on the first interface coating layer (18).

9. The method or ceramic matrix composite of any preceding claim, wherein the high entropy ceramic comprises at least one of a high entropy carbide, a high entropy nitride, a high entropy carbonitride, and a high entropy boride.

10. The method or ceramic matrix composite of claim 9, wherein the high entropy ceramic comprises at least four cations, including a refractory metal cation selected from group consisting of titanium, chromium, zirconium, hafnium, vanadium, niobium, tantalum, molybdenum, and tungsten.

11. The method or ceramic matrix composite of claim 10, wherein each refractory metal cation makes up at least 5 atomic percent of the cations of the high entropy ceramic.

12. The method of any of claims 7 to 11, wherein depositing the first protective layer (22; 38; 48) comprises simultaneously flowing, into a reaction chamber containing the fiber (12; 32; 42):
a first gas comprising precursors of a first refractory material;
a second gas comprising precursors of a second refractory material;
a third gas comprising precursors of a third refractory material; and
a fourth gas comprising precursors of a fourth refractory material,
wherein the first, second, third, and fourth refractory materials are different, wherein, optionally, the first, second, third, and fourth refractory materials comprise at least one of a refractory carbide, a refractory nitride, a refractory carbonitride, and a refractory boride.

13. The method of claim 12, wherein flowing the first, second, third, and fourth gases comprises modulating a gas flow rate of each of the first, second, third, and fourth gases to account for variations in kinetics between the first, second, third, and fourth gases and to produce a high entropy ceramic.

14. The method or ceramic matrix composite of any preceding claim, wherein the first interface coating layer (18; 36; 46) is boron nitride, or silicon-doped boron nitride, or a combination thereof.

15. The method of any of claims 7 to 14, and further comprising depositing, by chemical vapor infiltration, a matrix material (34; 44) between the first interface coating layer (36; 46) and the first protective layer (38; 48).
